# EUROPEAN PATENT APPLICATION

(11) **EP 4 131 343 A1**
(43) Date of publication of application: **08.02.2023**
(21) Application number: 20929450.3
(22) Date of filing: 03.04.2020
(51) Int. Cl.: H01L 21/304

(54) **POLISHING METHOD, AND PRODUCTION METHOD FOR SEMICONDUCTOR SUBSTRATE**

(71) Applicant: MITSUBISHI ELECTRIC CORPORATION, Chiyoda-ku Tokyo 100-8310 (JP)
(72) Inventor: HIZA, Shuichi, Tokyo 100-8310 (JP); NISHIMURA, Kunihiko, Tokyo 100-8310 (JP); TAKIGUCHI, Yuki, Tokyo 100-8310 (JP); YAGYU, Eiji, Tokyo 100-8310 (JP)
(74) Representative: Sajda, Wolf E.
(86) International application number: PCT/JP2020/015322
(87) International publication number: WO 2021/199426

(57) **Abstract**

The present invention relates to a semiconductor substrate manufacturing method including: forming a catalytic metal film composed of a transition metal on a main surface to be polished of a workpiece substrate composed of any one of diamond, silicon carbide, gallium nitride, and sapphire; and providing relative movement between the workpiece substrate on which the catalytic metal film has been formed and a polishing platen in an oxidant solution to remove a compound generated by chemical reaction of an active radical generated by reaction of the catalytic metal film and the oxidant solution and a surface atom on the main surface of the workpiece substrate to thereby polish the workpiece substrate. The manufacturing method further includes: preparing a support substrate and an epitaxial substrate including a growth substrate and a nitride semiconductor layer formed on a main surface of the growth substrate, and bonding the nitride semiconductor layer of the epitaxial substrate and the support substrate via a resin adhesive layer; and removing the growth substrate to expose the nitride semiconductor layer. The manufacturing method further includes: bonding the polished workpiece substrate to the nitride semiconductor layer by room temperature bonding; and removing the support substrate and the resin adhesive layer.

## Description

### Technical Field

The present invention relates to semiconductor substrate manufacturing methods and, in particular, to a method of manufacturing a semiconductor substrate including a nitride semiconductor layer.

### Background Art

As a high power semiconductor device, a field-effect transistor including a nitride semiconductor, such as a high electron mobility transistor (HEMT), is known. Operating characteristics and reliability of such a semiconductor device significantly decrease due to a temperature rise during high power operation. A highly heat dissipating material is often provided near a heat generating portion for heat dissipation to suppress the temperature rise of the semiconductor device.

In particular, diamond is a material having the highest thermal conductivity among solid materials, and thus has suitable properties as a heat dissipating material. Technology of forming a nitride semiconductor layer on diamond to improve heat dissipation of the semiconductor device is thus disclosed.

Technology of heteroepitaxially growing the nitride semiconductor layer on a substrate composed of silicon (Si), silicon carbide (SiC), sapphire (Al₂O₃), and the like is established as technology of manufacturing the nitride semiconductor layer, and is widely used as part of technology of manufacturing a nitride semiconductor device.

On the other hand, technology of heteroepitaxially growing the nitride semiconductor layer directly on a diamond substrate is still under investigation, and a process thereof has not been established. A scheme of bonding the semiconductor layer and the diamond substrate for integration is known as an example of technology for manufacturing a composite substrate including a highly heat dissipating substrate composed of diamond and the like and the semiconductor layer formed on the highly heat dissipating substrate.

Metal solder, an adhesive, or the like is sometimes used to bond the semiconductor layer and the substrate composed of diamond and the like in such a scheme, but, in a case where importance is placed particularly on heat dissipation performance, bonding targets are required to be directly bonded.

To achieve direct bonding of such dissimilar materials, surfaces of bonding target materials are required to be smoothed on an atomic layer-level order.

As a scheme of precisely smoothing a semiconductor and a metal material, a scheme, such as chemical mechanical polishing, of polishing a surface of a material using a mixture of a chemical solution and abrasive particles is known. However, it is difficult to smooth a difficult-to-machine material, such as diamond, having high chemical stability on the atomic layer-level order by chemical mechanical polishing.

As a scheme of smoothing a material having such low processability on the atomic layer-level order, Patent Document 1 discloses technology of using highly reactive active radicals generated by catalytic reaction in a polishing solution, for example. In such a scheme, a metal platen composed of a catalyst is immersed in a polishing liquid, and radicals generated by reaction in the polishing liquid act on a point of contact between the metal platen and a workpiece, and allow a compound to leach from the surface of the workpiece and to be removed for polishing.

### Prior Art Document

### Patent Document

Patent Document 1: Japanese Patent Application Laid-Open JP 2006- 114 632 A

### Summary

### Problem to be Solved by the Invention

In a processing scheme using catalytic reaction, active radicals generated by reaction of a catalytic metal and a polishing solution are highly reactive and short-lived, so that action thereof is effective only near a point of generation thereof. Polishing is typically performed by providing relative movement between a workpiece and a polishing platen while bringing them into contact with each other. Polishing action in the scheme has a local onset of oxidation action and smoothing action due to action of active radicals generated mainly around a point of contact between a protruding region of micrometer-level asperity of the surface of the metal platen and a protruding region of micrometer-level asperity of the surface of the workpiece at some time, and, due to repetition thereof, processing of the whole surface of the workpiece gradually proceeds. Prolonged polishing is thus required to exert polishing action on the whole surface of the workpiece, and thus high polishing efficiency cannot be obtained.

The present invention has been conceived to solve a problem as described above, and it is an object of the present invention to provide a manufacturing method to achieve a high-quality and low-cost semiconductor substrate including a substrate composed of a difficult-to-machine material, such as diamond, having high chemical stability and a semiconductor layer formed on the substrate.

### Means to Solve the Problem

A polishing method according to the present invention is a polishing method of polishing a workpiece substrate composed of any one of diamond, silicon carbide, gallium nitride, and sapphire, the polishing method including:
(a) forming a catalytic metal film composed of a transition metal on a main surface to be polished of the workpiece substrate;
(b) providing relative movement between the workpiece substrate on which the catalytic metal film has been formed and a polishing platen in an oxidant solution to remove a compound generated by chemical reaction of an active radical generated by reaction of the catalytic metal film and the oxidant solution and a surface atom on the main surface of the workpiece substrate to thereby polish the workpiece substrate.

### Effects of the Invention

According to the polishing method according to the present invention, the catalytic transition metal film is formed in advance on the main surface of the workpiece substrate, and thus the active radical is generated over the whole main surface of the workpiece substrate having micrometer-level asperity by reaction of the oxidant solution and the transition metal to cause oxidation action. A region where polishing action is effectively exerted thus increases to significantly improve polishing efficiency.

### Brief Description of Drawings

FIG. 1 is a cross-sectional view for describing a polishing method in Embodiment 1.
FIG. 2 is a cross-sectional view for describing the polishing method in Embodiment 1.
FIG. 3 schematically shows a configuration of a polishing apparatus used for polishing of a workpiece substrate by the polishing method in Embodiment 1.
FIG. 4 is a cross-sectional view illustrating the workpiece substrate polished by the polishing method in Embodiment 1.
FIG. 5 is a cross-sectional view illustrating a semiconductor substrate manufactured by a semiconductor substrate manufacturing method in Embodiment 2.
FIG. 6 is a cross-sectional view for describing the semiconductor substrate manufacturing method in Embodiment 2.
FIG. 7 is a cross-sectional view for describing the semiconductor substrate manufacturing method in Embodiment 2.
FIG. 8 is a cross-sectional view for describing the semiconductor substrate manufacturing method in Embodiment 2.
FIG. 9 is a cross-sectional view for describing the semiconductor substrate manufacturing method in Embodiment 2.
FIG. 10 is a cross-sectional view for describing the semiconductor substrate manufacturing method in Embodiment 2.
FIG. 11 is for describing polishing conditions of the polishing method in Embodiment 1.

### Description of Embodiments

A polishing method and a semiconductor substrate manufacturing method according to the present invention will be described below with reference to the drawings. The drawings are schematically shown, the sizes of and a positional correlation between images illustrated in different drawings are not necessarily accurate, and a dimensional relationship and a ratio along the length, the depth, and the height are different from real ones. In description made below, similar components bear the same reference signs, and have similar names and functions. Detailed description thereof is sometimes omitted.

### Embodiment 1

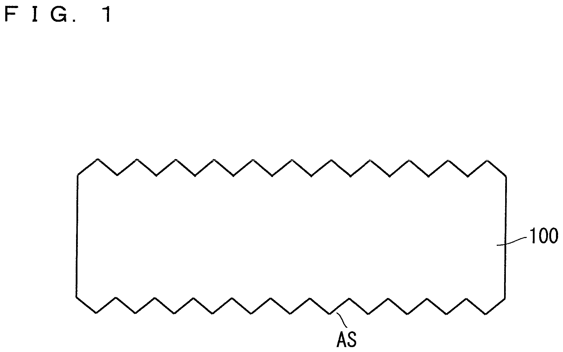

A polishing method in Embodiment 1 according to the present invention will be described with reference to FIGS. 1 to 4. First, in a step illustrated in FIG. 1, a workpiece substrate 100 to be polished is prepared. While any of diamond, silicon carbide (SiC), and gallium nitride (GaN) can be used as a material for the workpiece substrate 100, it is particularly preferable to use diamond having extremely high thermal conductivity in view of formation of a nitride semiconductor layer. Micrometer-level asperity AS of a surface of the workpiece substrate 100 is emphasized in FIG. 1 and other drawings.

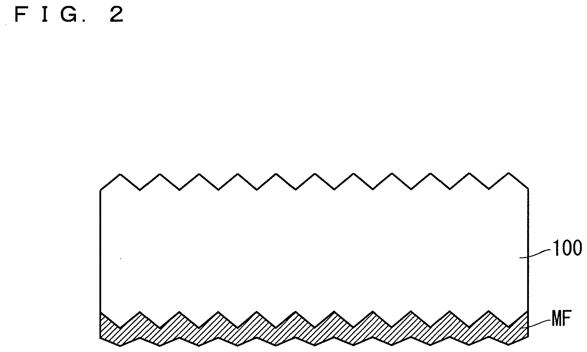

Next, in a step illustrated in FIG. 2, a catalytic metal film MF composed of transition metal elements is formed on a main surface to be polished of two main surfaces of the workpiece substrate 100. The main surface on which the catalytic metal film MF is formed is a main surface on which the nitride semiconductor layer is formed later.

While the catalytic metal film MF can be formed by a known formation method, such as vacuum deposition, sputtering, and plating, it is particularly preferable to use sputtering in terms of improvement in adhesion between the workpiece substrate 100 and the catalytic metal film MF.

While the catalytic metal film MF may be of any type as long as it reacts with an oxidant solution used as a polishing solution and generates radicals having chemical activity (active radicals), it is particularly preferable to use nickel or iron to effectively generate the active radicals.

The catalytic metal film MF preferably has a thickness greater than a value of a maximum height difference of the fine asperity AS of the main surface of the workpiece substrate 100 measured by a scanning white light interferometer in terms of improvement in substrate polishing efficiency. A maximum value of the thickness of the catalytic metal film MF is preferably less than ten times the maximum height difference of the fine asperity AS.

Radicals generated in a case where aqueous hydrogen peroxide is used as the oxidant solution and iron is used as the catalytic metal film MF composed of the transition metal elements are active radicals referred to as hydroxyl radicals (OH^{·}), and generation reaction thereof is well known as the Fenton reaction expressed by the following chemical formula (1).

Fe²⁺ + H₂O₂ → Fe³⁺ + OH⁻ + OH ... (1)

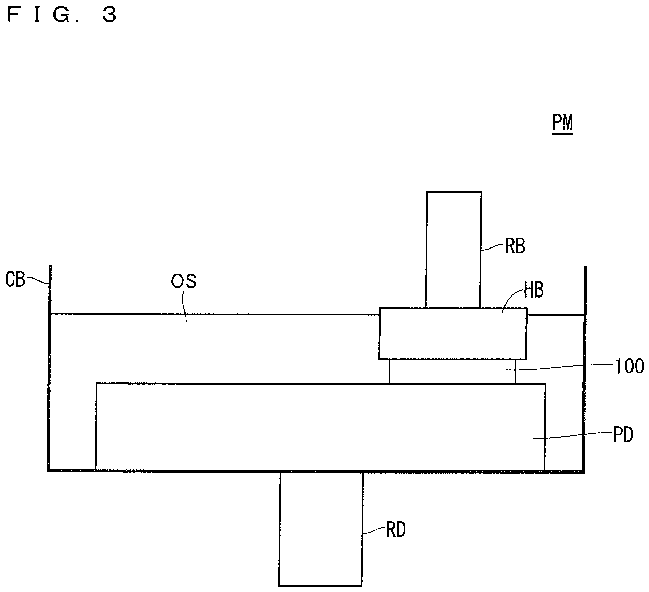

Next, the workpiece substrate 100 on which the catalytic metal film MF has been formed is polished using a polishing apparatus PM illustrated in FIG. 3. FIG. 3 schematically shows a configuration of the polishing apparatus PM.

As illustrated in FIG. 3, the polishing apparatus PM includes a chemical bath CB storing an oxidant solution OS, a polishing platen PD connected to a platen rotation mechanism RD and mounting thereon the workpiece substrate 100 to face the catalytic metal film MF in the chemical bath CB, a substrate holding board HB holding the workpiece substrate 100 on the polishing platen PD, and a substrate rotation mechanism RB rotating the workpiece substrate 100 via the substrate holding board HB under pressure while pressing the workpiece substrate 100 against the polishing platen PD.

The polishing platen PD of the polishing apparatus PM has a reference surface of polishing, and can be composed of any metal, ceramics, inorganic oxides, and the like, but is preferably composed of a material reacting with the oxidant solution OS, such as aqueous hydrogen peroxide, and generating the active radicals, and is particularly preferably composed of iron or nickel to effectively generate the active radicals.

The oxidant solution OS stored in the chemical bath CB of the polishing apparatus PM is preferably a solution generating the active radicals due to reaction with a transition metal, and is particularly preferably aqueous hydrogen peroxide.

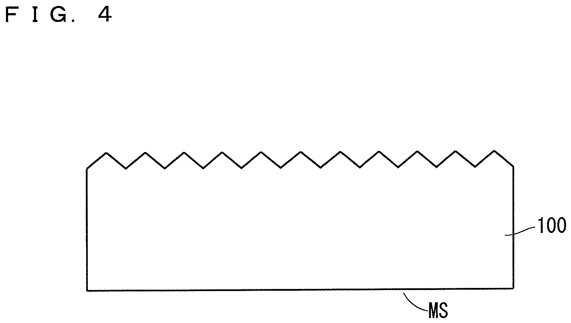

The workpiece substrate 100 on which the catalytic metal film MF (FIG. 2) has been formed is attached to the polishing apparatus PM having such a configuration, and a polishing process is performed, so that the micrometer-level asperity AS of the main surface of the workpiece substrate 100 on which the catalytic metal film MF has been formed is smoothed. FIG. 4 illustrates the workpiece substrate 100 having a main surface MS smoothed by removing the asperity AS of the main surface to be polished.

While any polishing conditions can be used as long as the main surface of the workpiece substrate 100 is smoothed, polishing conditions under which 1 wt% of aqueous hydrogen peroxide is used as the oxidant solution OS, the workpiece substrate 100 is rotated at 50 rpm, the polishing platen PD is rotated at 50 rpm, and the workpiece substrate 100 is pressed at a pressure of 0.5 MPa can be used, for example.

By forming the catalytic metal film MF on the main surface of the workpiece substrate 100 in advance for polishing as described above, the active radicals are generated over the whole main surface of the workpiece substrate by reaction of the oxidant solution and the transition metal, oxidation action is exerted on the main surface of the workpiece substrate 100 due to the active radicals, and a compound is generated by chemical reaction with surface atoms on the main surface of the workpiece substrate.

The compound is removed by relative movement between the workpiece substrate 100 and the polishing platen PD, so that the main surface of the workpiece substrate 100 is polished. Compared with a case where polishing is performed without forming the catalytic metal film MF on the workpiece substrate 100, polishing is promoted, and time until arithmetic surface roughness (Ra) of the whole main surface of the workpiece substrate 100 to be polished falls below 0.5 nm to complete polishing is significantly reduced. As a result, the workpiece substrate 100 having a high-quality smoothed surface can be manufactured at low cost.

### Embodiment 2

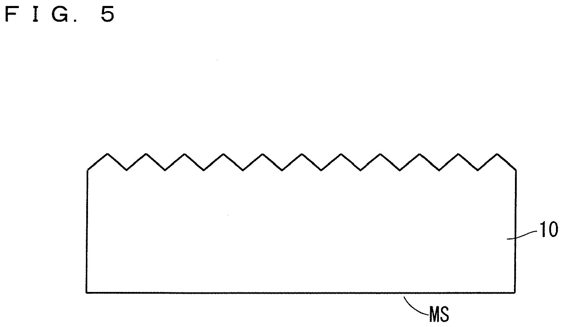

A semiconductor substrate manufacturing method in Embodiment 2 according to the present invention will be described next with reference to FIGS. 5 to 10.

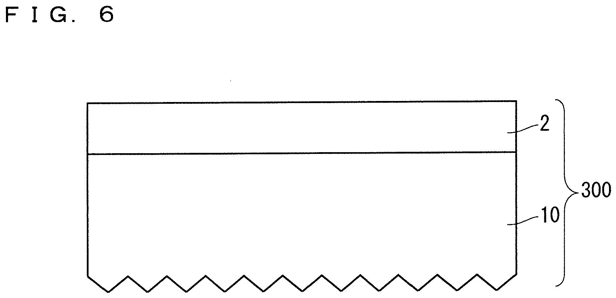

FIG. 6 is a cross-sectional view illustrating a configuration of a semiconductor substrate 300 manufactured by the manufacturing method in Embodiment 2. As illustrated in FIG. 6, the semiconductor substrate 300 includes a support substrate 10, such as a diamond substrate, having high thermal conductivity, and a semiconductor layer 2 formed on the support substrate 10 and composed of a semiconductor material, such as a nitride semiconductor, for example.

In a first step in Embodiment 2, a main surface to be polished of two main surfaces of the support substrate 10 is polished by the polishing method described in Embodiment 1 to obtain the support substrate 10 having the main surface MS having arithmetic surface roughness of less than 0.5 nm as illustrated in FIG. 5.

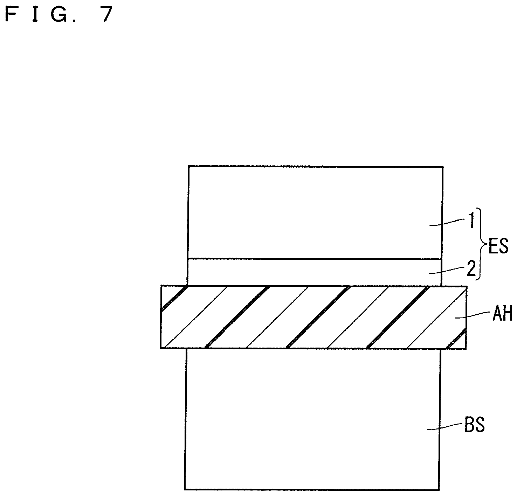

In a second step, as illustrated in FIG. 7, a support substrate BS is bonded, using a resin adhesive layer, to the semiconductor layer 2 (a nitride semiconductor layer) heteroepitaxially grown on a growth substrate 1, for example, and composed of a nitride semiconductor and the like.

In the second step, an epitaxial substrate ES including the growth substrate 1, such as an Si substrate, and the semiconductor layer 2 heteroepitaxially grown on a main surface of the growth substrate 1 and composed of a nitride semiconductor and the like is prepared first. An electron device, such as a diode, a transistor, and a resistor, may be formed on the semiconductor layer 2 in advance.

The support substrate BS selected from a glass substrate, a sapphire substrate, an Si substrate, an SiC substrate, and the like is then prepared, and the epitaxial substrate ES and the support substrate BS are bonded with a resin adhesive so that a main surface of the epitaxial substrate ES on a side where the semiconductor layer 2 is formed and a main surface (first surface) of the support substrate BS for bonding face each other to cause the epitaxial substrate ES and the support substrate BS to adhere to each other using a resin adhesive layer AH.

While a known resin adhesive, such as an acrylic resin, an epoxy resin, a silicone resin, a modified silicone resin, and an alumina adhesive, can be used as the resin adhesive, a non-solvent diluted adhesive curing due to chemical reaction is preferably used, and the acrylic resin, the epoxy resin, the silicone resin, and the like are preferably used, for example.

Curing is performed after bonding to improve the mechanical strength of the resin adhesive layer AH. While any curing conditions can be used depending on the resin adhesive layer AH to be used, heating is performed in a blast drying oven at 70 °C for six hours, for example.

The support substrate BS has a role in supporting the semiconductor layer 2 in a subsequent step, and thus is not limited to the above-mentioned substrate and may be composed of any material as long as it can withstand the step in terms of heat resistance, mechanical strength, and resistance to a solution used in the manufacturing steps.

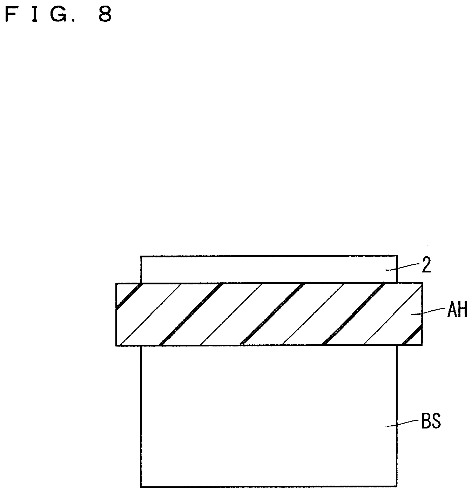

Next, in a third step, the growth substrate 1 is removed as illustrated in FIG. 8. While the growth substrate 1 can be removed from a main surface (back surface) opposite a main surface on which the semiconductor layer 2 has been formed by mechanical polishing, dry etching, wet etching with a solution, and the like, mechanical polishing is preferably used in terms of a removal rate.

Next, in a fourth step, a surface (back surface) of the semiconductor layer 2 from which the growth substrate 1 has been removed is polished for smoothing. While a known smoothing method, such as mechanical polishing, chemical mechanical polishing (CMP), dry etching, and wet etching with a solution, can be used, chemical mechanical polishing is preferably used as high smoothing quality is required to improve bonding quality in the following bonding step.

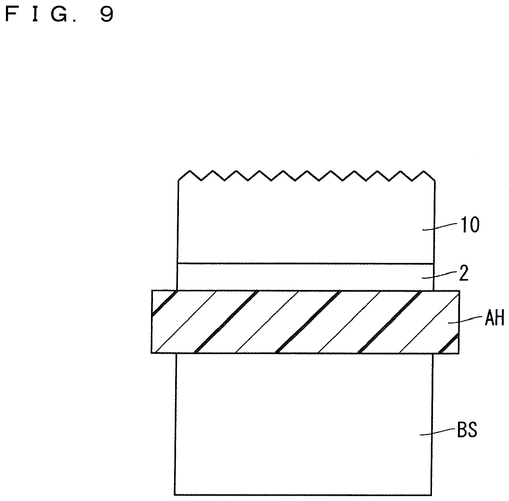

In a fifth step, the support substrate 10 obtained in the first step is bonded to the back surface of the semiconductor layer 2 as illustrated in FIG. 9. The support substrate 10 is composed of a diamond substrate having high thermal conductivity in view of improvement in operating characteristics and reliability of a nitride semiconductor device formed on the semiconductor layer 2.

While any direct bonding of dissimilar materials can be used to bond the support substrate 10 to the semiconductor layer 2, it is preferable to reduce as much thermal resistance as possible at an interface between the semiconductor layer 2 and the support substrate 10 to improve performance and reliability of the nitride semiconductor device.

It is also preferable to bond the semiconductor layer 2 and the support substrate 10 without heating to prevent warpage of the substrate after bonding. It is thus most preferable to perform room temperature bonding. One example of room temperature bonding is surface activated room temperature bonding, which is a method of surface treating a bonding surface in a vacuum to perform bonding with surface atoms being active to facilitate chemical bonding.

Atomic diffusion bonding and hydrophilic group pressure bonding can be used as room temperature bonding. Atomic diffusion bonding is a method of forming metal films on surfaces of bonding targets by sputtering and the like, and bringing the metal films into contact with each other in a vacuum for bonding.

Hydrophilic group pressure bonding is a method of performing hydrophilization to cause many hydroxyl groups to adhere to the surfaces of the bonding targets while slightly oxidizing the surfaces to form thin oxide films, and then bonding the hydrophilized surfaces in the stack under pressure.

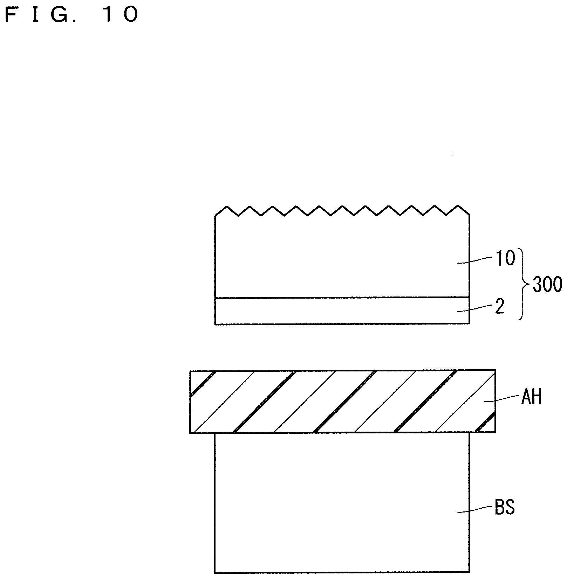

Finally, in a sixth step, the support substrate BS and the resin adhesive layer AH on a side opposite the support substrate 10 are removed to obtain the semiconductor substrate 300 including the support substrate 10 and the semiconductor layer 2 formed on the support substrate 10 as illustrated in FIG. 10.

A known removal method, such as a method of mechanically peeling the resin adhesive layer AH from the support substrate 10 along with the support substrate BS, a method of immersing the resin adhesive layer AH in a solvent for embrittlement of physical properties, and then mechanically peeling the resin adhesive layer AH from the support substrate 10, a method of heat treating the resin adhesive layer AH for combustion to remove the support substrate BS, and a method of treating the resin adhesive layer AH with sulfuric peroxide for combustion to remove the support substrate BS, can be used.

The semiconductor substrate 300 manufactured by the semiconductor substrate manufacturing method in Embodiment 2 described above includes the support substrate 10, such as the diamond substrate, having high thermal conductivity smooth polished at an atomic layer level with high efficiency and the semiconductor layer 2 composed of a nitride semiconductor and the like formed on the support substrate 10.

The semiconductor layer 2 is a semiconductor layer heteroepitaxially grown on the growth substrate different from the support substrate 10, and is transferred onto the support substrate 10 with a crystal plane at heteroepitaxial growth maintained. A high-quality nitride semiconductor device can thereby be formed on the semiconductor layer 2. The diamond substrate can be smooth polished with high efficiency by using the polishing method in Embodiment 1, and thus the semiconductor substrate 300 can be manufactured at low cost.

### Modifications

While the semiconductor layer 2 is heteroepitaxially grown on the main surface of the growth substrate 1 in Embodiments 1 and 2 described above, the semiconductor layer 2 is not limited to the heteroepitaxially grown semiconductor layer, and may be composed of a homoepitaxially grown semiconductor film.

### Examples

Examples of the polishing method in Embodiment 1 and the semiconductor substrate manufacturing method in Embodiment 2 will be described in details below as Examples 1 to 4, but implementation conditions are not limited to those of Examples 1 to 4.

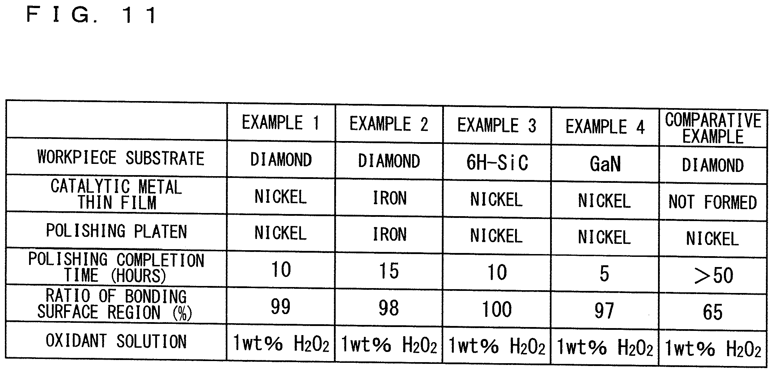

FIG. 11 shows polishing conditions of the polishing method in Embodiment 1 for each of Examples 1 to 4 and Comparative Example as a list. Materials for the workpiece substrate and the catalytic metal film as used, polishing completion time, a ratio of a bonding surface region (%), a type of the oxidant solution, and a material for the polishing platen are shown for each of Examples 1 to 4 and Comparative Example in FIG. 11.

### Type of Workpiece Substrate

In each of Examples 1 and 2 and Comparative Example, diamond was used as the workpiece substrate. In Example 3, a 6H-SiC substrate was used as the workpiece substrate. In Example 4, a GaN substrate was used as the workpiece substrate. The workpiece substrate was used after being cut to a 10 mm square size.

### Type of Catalytic Metal Film

In each of Examples 1, 3 and 4, a nickel film formed by sputtering was used as the catalytic metal film. The nickel film had a thickness of 10 µm.

In Example 2, an iron film formed by sputtering was used as the catalytic metal film. The iron film had a thickness of 10 µm. In Comparative Example, polishing was performed without forming the catalytic metal film on the workpiece substrate.

### Polishing Platen

In each of Examples 1, 3, and 4 and Comparative Example, nickel was used as a material for the polishing platen used in the polishing apparatus. In Example 2, cast iron was used as a material for the polishing platen used in the polishing apparatus.

### Oxidant Solution

In polishing of the workpiece substrate in each of Examples 1 to 4 and Comparative Example, aqueous hydrogen peroxide diluted to 1 wt% was used as the oxidant solution.

### Evaluation of Shape of Substrate Main Surface

A change in shape of the main surface before and after polishing of the workpiece substrate in each of Examples 1 to 4 and Comparative Example was evaluated by an optical shape evaluation scheme using a scanning white light interferometer.

Evaluation was performed with a 90 µm square field of view at a total of five points including one point at an in-plane center in the substrate having the 10 mm square size and four points at the corners of the substrate.

### Polishing Conditions

As the polishing conditions of the workpiece substrate for each of Examples 1 to 4 and Comparative Example, polishing was performed at a pressure of 0.5 MPa, the workpiece substrate was rotated at 50 rpm, and the polishing platen was rotated at 50 rpm. The workpiece substrate was removed from the polishing apparatus every five hours during polishing for evaluation of the shape of the main surface, polishing was considered to be completed when arithmetic surface roughness (Ra) falls below 0.5 nm at all the points for shape measurement on the main surface of the workpiece substrate, and polishing was performed for up to 50 hours while polishing and evaluation of the shape of the main surface of the substrate were repeated.

### Manufacture of Semiconductor Substrate Including Semiconductor Layer

In each of Examples 1 to 4 and Comparative Example, a gallium nitride film was heteroepitaxially grown on the Si substrate to obtain the nitride semiconductor layer, the nitride semiconductor layer was caused to adhere to the support substrate composed of the glass substrate with an acrylic adhesive, the Si substrate was removed by mechanical grinding, and the removed surface was precisely polished by chemical mechanical polishing. The gallium nitride film adhering to the glass substrate and the workpiece substrate formed in each of Examples 1 to 4 and Comparative Example were then bonded by surface activated room temperature bonding to manufacture the semiconductor substrate in which the nitride semiconductor layer and the workpiece substrate are integrated.

### Evaluation of Semiconductor Substrate

In each of Examples 1 to 4 and Comparative Example, bonding quality of the manufactured semiconductor substrate, herein, a ratio of the area of a region where a bonding failure (interfacial void) remains to the area of the main surface of the workpiece substrate was evaluated by ultrasonic flaw detection, and a ratio of the area of a region where the interfacial void does not remain was considered as the ratio of the bonding surface region.

### Results of Evaluation of Workpiece Surface after Polishing and Composite Substrate

In each of Examples 1 to 4, the catalytic metal film composed of the transition metal elements was formed on the surface of the workpiece substrate in advance for polishing. Polishing action is thus more effectively exerted on the whole surface of the substrate, and, as shown in FIG. 11, time to complete polishing of the main surface of the substrate (polishing completion time) was within 20 hours in each of Examples 1 to 4, which was shorter than more than 50 hours in Comparative Example.

In results of evaluation of the bonding quality of the semiconductor substrate manufactured in each example, the ratio of the bonding surface region in each of Examples 1 to 4 was approximately 100% as shown in FIG. 11, and a bond was formed over the whole main surface of the workpiece substrate.

On the other hand, in Comparative Example, polishing was performed without forming the catalytic metal film on the surface of the workpiece substrate, so that a region where polishing action is effectively exerted is limited, and polishing on the whole main surface of the workpiece substrate was not completed even after continuation of polishing for 50 hours. Furthermore, the bonding failure occurred in a region of the area of 35% as a result of evaluation of the bonding quality of the semiconductor substrate by ultrasonic flaw detection.

As described above, according to the polishing method and the semiconductor substrate manufacturing method according to the present invention, the diamond substrate can be smooth polished with high efficiency, so that a high-quality and low-cost semiconductor substrate including the diamond substrate having high heat dissipation and the nitride semiconductor layer formed on the diamond substrate can be manufactured.

While the present invention has been described in detail, the foregoing description is in all aspects illustrative and not restrictive. It is understood that numerous unillustrated modifications can be devised without departing from the scope of the present invention.

Embodiments of the present invention can freely be combined with each other, and can be modified or omitted as appropriate within the scope of the present invention.

## Claims

1. A polishing method of polishing a workpiece substrate composed of any one of diamond, silicon carbide, gallium nitride, and sapphire, the polishing method comprising:
(a) forming a catalytic metal film composed of a transition metal on a main surface to be polished of the workpiece substrate; and
(b) providing relative movement between the workpiece substrate on which the catalytic metal film has been formed and a polishing platen in an oxidant solution to remove a compound generated by chemical reaction of an active radical generated by reaction of the catalytic metal film and the oxidant solution and a surface atom on the main surface of the workpiece substrate to thereby polish the workpiece substrate.

2. The polishing method according to claim 1,
wherein the step (a) includes
forming the catalytic metal film using iron or nickel, and
in the step (b),
aqueous hydrogen peroxide is used as the oxidant solution.

3. The polishing method according to claim 1,
wherein the step (a) includes
forming the catalytic metal film so that the catalytic metal film has a thickness greater than a value of a maximum height difference of asperity of the main surface of the workpiece substrate and less than ten times the maximum height difference.

4. The polishing method according to claim 2,
wherein the polishing platen is composed of iron or nickel.

5. A semiconductor substrate manufacturing method comprising:
(a) forming a catalytic metal film composed of a transition metal on a main surface to be polished of a workpiece substrate composed of any one of diamond, silicon carbide, gallium nitride, and sapphire;
(b) providing relative movement between the workpiece substrate on which the catalytic metal film has been formed and a polishing platen in an oxidant solution to remove a compound generated by chemical reaction of an active radical generated by reaction of the catalytic metal film and the oxidant solution and a surface atom on the main surface of the workpiece substrate to thereby polish the workpiece substrate;
(c) preparing a support substrate and an epitaxial substrate including a growth substrate as a semiconductor substrate and a nitride semiconductor layer epitaxially grown on a main surface of the growth substrate, and forming a resin adhesive layer between the nitride semiconductor layer on the growth substrate and a main surface of the support substrate to bond the epitaxial substrate and the support substrate;
(d) after the step (c), removing the growth substrate to expose the nitride semiconductor layer;
(e) after the step (d), bonding the workpiece substrate polished in the step (b) to the nitride semiconductor layer by room temperature bonding; and
(f) after the step (e), removing the support substrate and the resin adhesive layer.

6. The semiconductor substrate manufacturing method according to claim 5,
wherein the step (a) includes
forming the catalytic metal film using iron or nickel, and
in the step (b),
aqueous hydrogen peroxide is used as the oxidant solution.

7. The semiconductor substrate manufacturing method according to claim 5,
wherein the step (a) includes
forming the catalytic metal film so that the catalytic metal film has a thickness greater than a value of a maximum height difference of asperity of the main surface of the workpiece substrate and less than ten times the maximum height difference.

8. The semiconductor substrate manufacturing method according to claim 6, wherein the polishing platen is composed of iron or nickel.
